**Europäisches Patentamt**

**European Patent Office**

**Office européen des brevets**

(19)

(11) Numéro de publication: **0 296 009**
**A1**

## (12) DEMANDE DE BREVET EUROPEEN

(21) Numéro de dépôt: **88401347.5**

(22) Date de dépôt: **03.06.88**

(51) Int. Cl.⁴: **H 01 P 7/10**

(30) Priorité: **09.06.87 FR 8708004**

(43) Date de publication de la demande:
**21.12.88 Bulletin 88/51**

(84) Etats contractants désignés: **DE GB IT NL**

(71) Demandeur: **THOMSON-CSF**
**173, Boulevard Haussmann**
**F-75379 Paris Cédex 08 (FR)**

(72) Inventeur: **Rouger, Jean-Michel**
**Thomson-CSF 19, avenue de Messine**
**F-75008 Paris (FR)**

**Denis, Gilles**
**Thomson-CSF 19, avenue de Messine**
**F-75008 Paris (FR)**

**Liabeuf, Bernard**
**Thomson-CSF 19, avenue de Messine**
**F-75008 Paris (FR)**

(74) Mandataire: **Benoit, Monique et al**
**THOMSON-CSF SCPI 19, avenue de Messine**
**F-75008 Paris (FR)**

(54) **Dispositif filtrant hyperfréquende accordable à résonateur diélectrique et applications.**

(57) La présente invention concerne un dispositf filtrant hyperfréquence accordable comportant une première ligne microruban (8), un résonateur diélectrique (5) couplé à ladite première ligne microruban (8), une ligne coplanaire (9) couplée au résonateur (5), un élément actif (7), comme par exemple un varactor, rapporté sur la ligne coplanaire (9), dont l'impédance variable permet d'accorder le dispositif en fréquence.

Application au dispositif selon l'invention à la réalisation d'un discriminateur de fréquence hyperfréquence accordable, à la réalisation d'un oscillateur hyperfréquence, à la stabilisation en fréquence d'un oscillateur accordable.

FIG. 4

EP 0 296 009 A1

**Description**

## DISPOSITIF FILTRANT HYPERFREQUENCE ACCORDABLE A RESONATEUR DIELECTRIQUE, ET APPLICATIONS

La présente invention concerne un dispositif filtrant, ou de sélection en fréquence, destiné à traiter des ondes hyperfréquences, fonctionnant par couplage entre au moins un résonateur diélectrique et au moins une ligne de transmission, comme par exemple une ligne microruban. Ce dispositif est accordable en fréquence au moyen d'une commande électronique. Il est notamment appliqué à la réalisation d'un oscillateur accordable, ainsi qu'à celle d'un discriminateur en fréquence accordable qui peut être utilisé dans un dispositif de stabilisation en fréquence d'un oscillateur accordable.

Pour certaines utilisations d'un tel dispositif, comme par exemple pour l'équipement d'un système radar, il est nécessaire de réaliser un dispositif agile en fréquence, accordable sur une large bande de fréquences, et possédant en outre une vitesse d'accord élevée ; pour équiper un système radar aéroporté ou à autodirecteur un tel dispositif doit de plus être le plus petit et le plus léger possible.

On connaît de tels dispositifs. L'un des dispositifs connus comporte :
- deux lignes microruban ;
- un résonatuer diélectrique situé, sur le substrat constituant le diélectrique desdites lignes, appelé simplement "substrat" dans ce qui suit, et suffisamment près de ces lignes pour pouvoir être couplé à chacune d'entre elles ;
- un varactor, c'est-à-dire une capacité susceptible de varier en fonction de la tension qu'on applique à ses bornes, rapporté sur l'une des lignes.

Un signal injecté dans le dispositif est filtré, et la fréquence centrale du dispositif filtrant obtenue est variable grâce à une commande de la tension appliquée au varactor.

Le dispositif connu n'est cependant accordable que sur une bande d'accord réduite par rapport, par exemple, à celle d'un dispositif filtrant comportant un résonateur à YIG, connu par l'homme du métier.

La présente invention propose de remplacer une des lignes microruban par une ligne coplanaire et de rapporter le varactor sur la ligne coplanaire.

Par rapport au dispositif connu, le dispositif selon l'invention est accordable sur une bande de fréquence plus étendue : en effet le couplage entre le résonateur et la ligne qui porte le varactor est plus fort, (la ligne sur laquelle est rapporté le varactor est de nature différente).

L'invention a plus précisément pour objet un dispositif filtrant hyperfréquence accordable comportant :
- une première ligne microruban ;
- un résonateur diélectrique couplé à ladite première ligne microruban ;
- un élément actif, couplé au résonateur diélectrique et dont l'impédance variable permet d'accorder le dispositif en fréquence ;
caractérisé en ce qu'il comporte en outre une ligne coplanaire couplée au résonateur, l'élément actif étant rapporté sur la ligne coplanaire.

Des particularités, différents modes de réalisation, et différentes applications du dispositif selon l'invention apparaîtront au cours de la description qui suit, à l'aide des figures que représentent :
- la figure 1, une vue en perspective du dispositif connu ;
- la figure 2, une vue de dessus de la figure 1 ;
- la figure 3, une vue en perspective d'un premier mode de réalisation du dispositif selon l'invention ;
- la figure 4, une vue de dessus de la figure 3 ;
- la figure 5, une vue de dessus d'un second mode de réalisation du dispositif selon l'invention ;
- la figure 6, une vue de dessus d'un troisième mode de réalisation du dispositif selon l'invention ;
- la figure 7, une illustration du couplage magnétique entre les éléments des figures 3 et 4.
- la figure 8, une illustration du couplage magnétique entre les éléments de la figure 5 ;
- la figure 9, une vue de dessus d'un quatrième mode de réalisation du dispositif selon l'invention.

Sur ces différentes figures, d'une part l'échelle réelle n'a pas été respectée, et d'autre part les mêmes références se rapportent aux mêmes éléments.

Dans ce qui suit, on se placera, à titre d'exemple, dans le cas où la partie du signal injecté dans le dispositif, qui est susceptible d'être traitée par ce dispositif, correspond à un mode transversal électrique, comme par exemple le mode $TE_{01}$ . Le couplage entre les différents éléments du dispositif est alors magnétique et se produit principalement dans une zone où l'amplitude des champs magnétiques des différents éléments couplés est élevée.

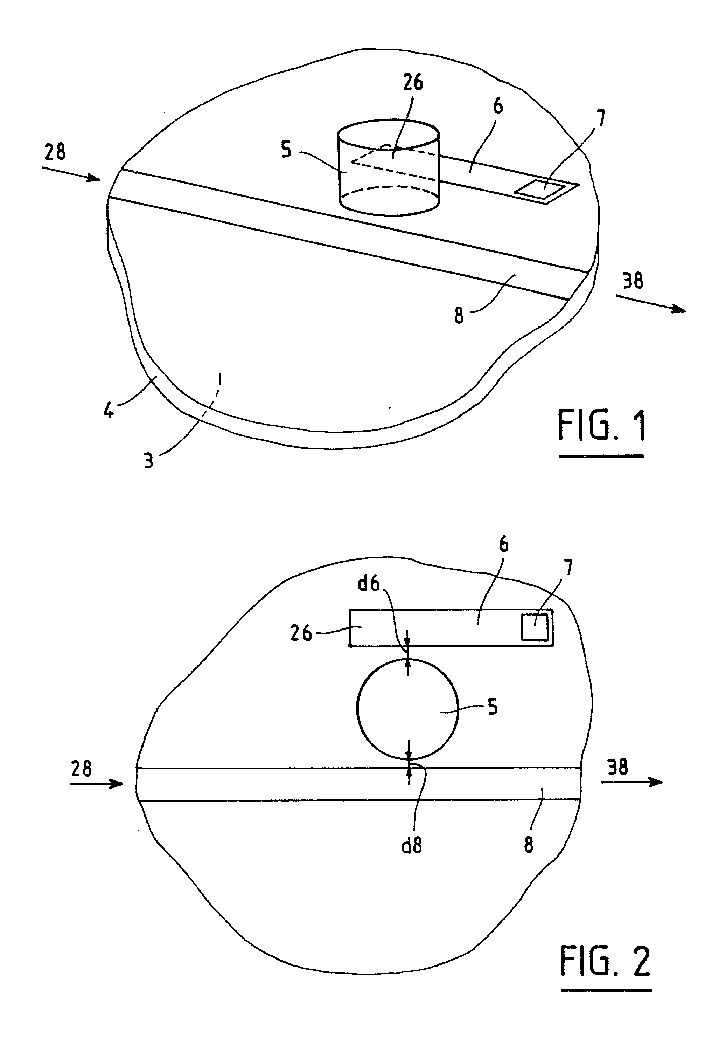

Un dispositif connu est représenté sur les figures 1 et 2, vu respectivement en perspective et de dessus.

Il comporte deux lignes microruban parallèles 8 et 6 ayant un substrat diélectrique 4 et un plan de masse 3 communs. La ligne 6 comporte une extrémité 26 en circuit ouvert. Un résonateur diélectrique cylindrique 5 est situé entre ces deux lignes 8 et 6, sur le substrat desdites lignes. Ce résonateur 5 est situé à une distance $d_8$, respectivement $d_6$, de la ligne 8, respectivement 6. Les distances $d_8$ et $d_6$ sont suffisamment faibles pour qu'un couplage magnétique entre les éléments 5 et 8 d'une part, et 5 et 6 d'autre part, soit possible. Un varactor 7 est rapporté sur l'extrémité opposée à l'extrémité 26 de la ligne 6.

Un signal hyperfréquence injecté à l'entrée 28 de la ligne 8, et récupéré à la sortie 38 de cette même ligne, est filtré. Le dispositif connu est accordable, comme cela a été expliqué précédemment.

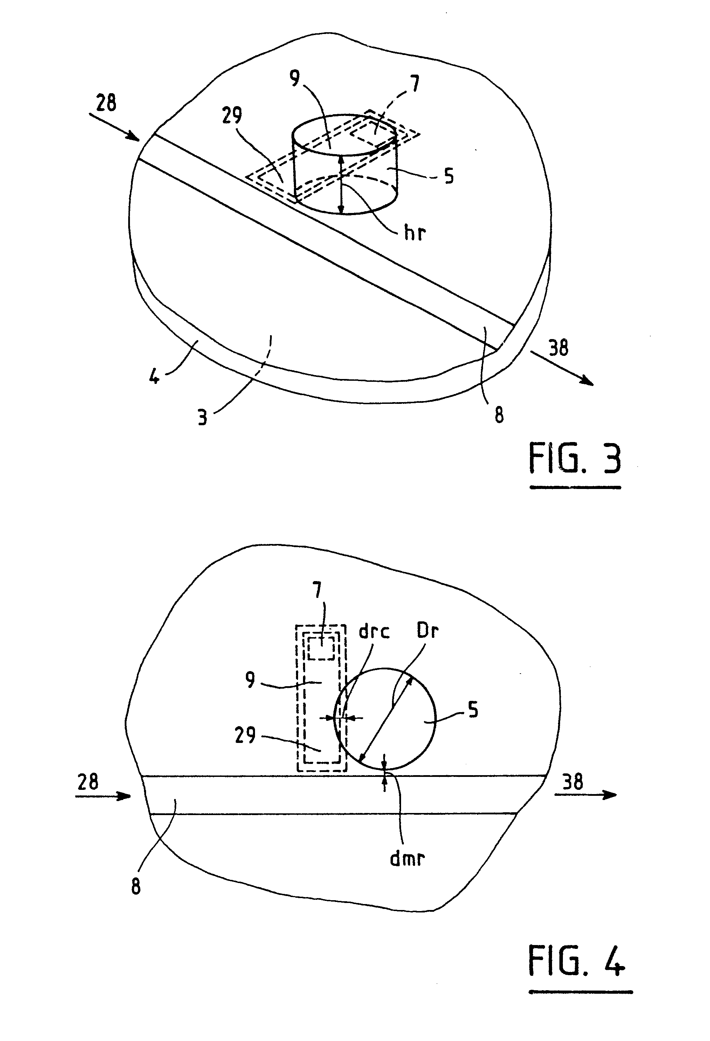

Les figures 3 et 4 représentent un premier mode de réalisation du dispositif selon l'invention, vu respectivement en perspective et des dessus. Un résonateur diélectrique cylindrique 5, dont les dimensions sont de l'ordre de la longueur d'onde injectée dans le dispositif, est placé à proximité d'une ligne microruban 8, sur le substrat de celle-ci, et à une distance $d_{mr}$ (entre la ligne microruban et le résonateur) suffisamment faible pour qu'un couplage entre les éléments 5 et 8 soit possible.

Les éléments 5 et 8 constituent un dispositif filtraant, dont la fréquence de résonance est commandable au moyen d'un circuit électronique qui comporte un ligne coplanaire 9, réalisée sur la face métallisée du substrat 4, qui constitue le plan de masse 3 des lignes microruban et coplanaire, et un varactor 7, rapporté sur la ligne 9. Cette ligne 9 est sensiblement perpendiculaire à la ligne 8, et comporte une extrémité 29 en circuit ouvert, le varactor 7 étant rapporté sur l'autre extrémité de la ligne 9.

La position de la ligne 9 par rapport au résonateur 5 est illustrée sur la figure 4 par la distance $d_{rc}$, mesurée dans un plan sensiblement parallèle aux faces du diélectrique 4 ; cette distance $d_{rc}$ est telle qu'un couplage entre la ligne 9 et le résonateur 5 soit possible : selon le mode de réalisation illustré par les figures 3 et 4, la ligne 9 est partiellement "sous" le résonateur 5 et la distance $d_{rc}$ mesure en fait le "recouvrement" entre les éléments 9 et 5, situés dans des plans sensiblement parallèles ; un couplage entre les éléments 9 et 5 peut cependant avoir lieu sans ce "recouvrement", c'est-à-dire dans le cas où la ligne 9 ne passe pas du tout "sous" le résonateur 5, mais reste alors près de ce résonateur 5.

D'autre part, selon le mode de réalisation considéré, la ligne 9 ne passe pas "sous" la ligne 8. Il est cependant possible de réaliser undispositif selon l'invention, analogue à celui des figures 3 et 4, comportant une ligne 9 passant "sous" la ligne 8, et même "dépassant" de celle-ci.

Le dispositif des figures 3 et 4, se comporte en transmission comme un filtre réjecteur de bande : un signal hyperfréquence injecté à l'entrée 28 de la ligne 8, et récupéré à la sortie 38 de cette même ligne, voit ses caractéristiques modifiées par une interaction entre les champs magnétiques résultants de l'excitation du résonateur 5 et ceux associés à la ligne 8 ; la fréquence de résonance du dispositif est variable au moyen de la commande de la tension V appliquée aux bornes du varactor 7 grâce à un couplage magnétique entre le résonateur 5 et la ligne 9 ; la bande d'accord du dispositif est d'autant plus étendue que le couplage entre le varactor 7 et le résonateur 5 est fort.

Les caractéristiques du dispositif, comme par exemple sa vitesse et sa bande d'accord, dépendent des paramètres suivants :
- permittivité du matériau constituant le résonateur 5, diamètre $D_r$ et hauteur $h_r$ de ce résonateur :
- permittivité et épaisseur de substrat 4 ;
- dimensions des lignes 9 et 8 ;
- agencement des différents éléments, donné en particulier par les distances $d_{mr}$ et $d_{rc}$, et la position des lignes 9 et 8 l'une par rapport à l'autre ;
- caractéristiques du varactor.

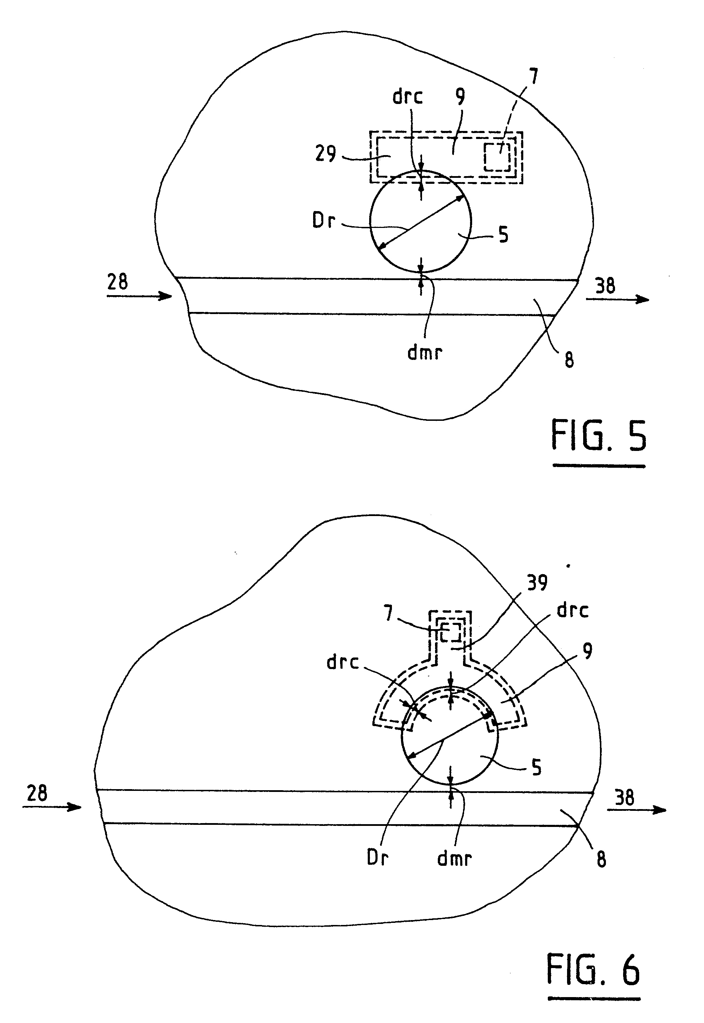

La figure 5 représente un second mode de réalisation du dispositif selon l'invention, vu des dessus, qui ne diffère du premier que par la position de la ligne 9 ; celle-ci est sensiblement parallèle à la ligne 8. la description de la figure 5 est analogue à celle des figures 3 et 4, sauf en ce qui concerne la position relative des éléments 8 et 9, fixée par les distances $d_{mr}$ et $d_{rc}$. La configuration des éléments de la figure 5 est cependant moins "souple" que celle qui correspond aux figures 3 et 4 : en effet, la position et les dimensions des lignes 9 et 8 limitent davantage le choix du diamètre et de la position du résonateur 5 dans le cas de la figure 5 que dans celui des figures 3 et 4 ; autrement dit, les paramètres dont dépendent les caractéristiques du dispositif sont plus corrélés dans le second mode de réalisation que dans le premier.

La figure 6 représente un troisième mode de réalisation du dispositif selon l'invention, vu de dessus, différent du second par la forme de la ligne 9. Celle-ci est courbe, et "entoure partiellement" le résonateur 5 : les éléments 9 et 5 sont concentriques et la ligne 9 forme un arc de cercle situé en partie sous le résonateur 5 mais aucunement sous la ligne 8. La ligne 9 comporte en outre une excroissance 39, sensiblement perpendiculaire à la direction de la ligne 8, sur laquelle est rapporté le varactor 7. La description de la figure 6 est analogue à celle de la figure 5, sauf en ce qui concerne l'extrémité 29 l'excroissance 39.

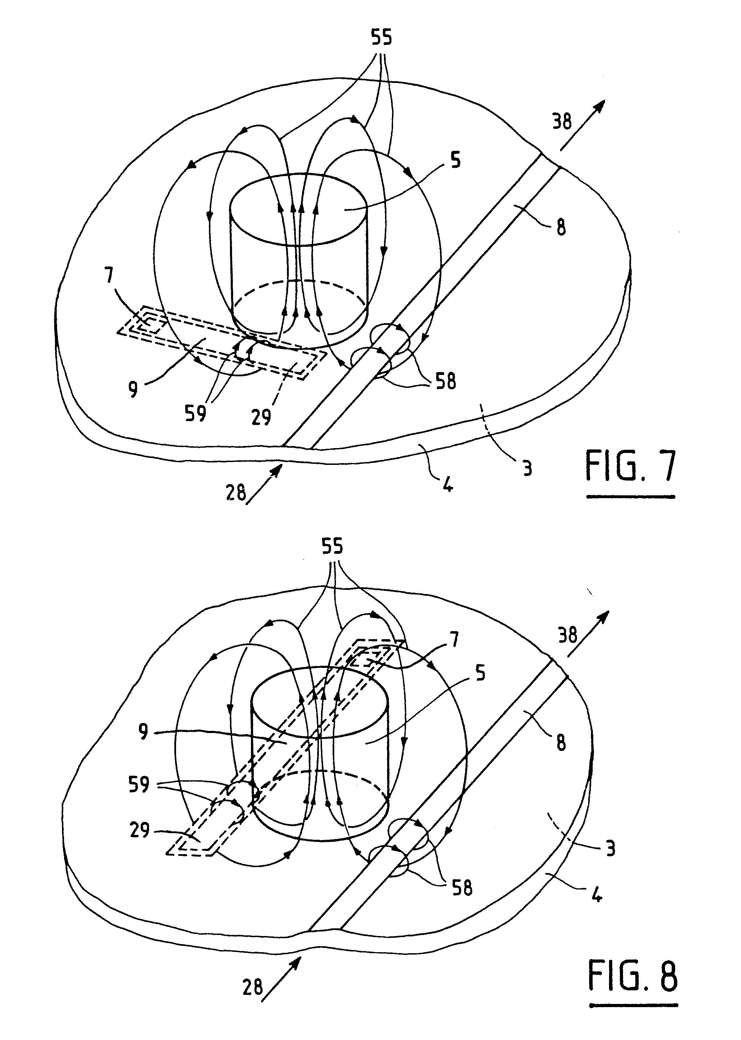

La figure 7 illustre le couplage magnétique entre les différents éléments des figures 3 et 4, grâce à la représentation des lignes de champ magnétique (55, 58, 59) associées aux différents éléments susceptibles d'être couplés. La similitude des lignes de champ 55, associées au résonateur 5, et 58, associées à la ligne microruban 8, garantit un couplage efficace entre les éléments 5 et 8. De même, la similitude des lignes de champ 55, associées au résonateur 5, et 59, associées à la ligne coplanaire 9, garantit un bon couplage entre les éléments 5 et 9.

La figure 8 est l'analogue de la figure 7 dans la configuration de la figure 5. La description de la figure 8 est semblable à celle de la figure 7.

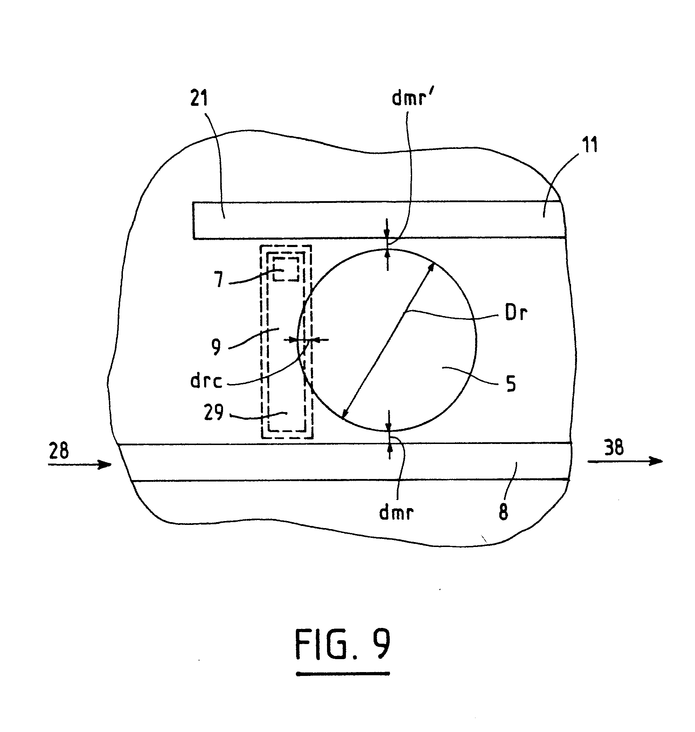

La figure 9 représente un quatrième mode de réalisation du dispositif selon l'invention, vu de dessus, qui comporte tous les éléments des figures 3 et 4, et qui comporte en outre une ligne microruban 11, dite secondaire, sensiblement parallèle à la ligne 8, dite principale, dont le substrat et le plan de masse sont ceux des lignes 8 et 9. La ligne 11 comporte une extrémité 21 en circuit ouvert. Elle est située à la distance $d_{mr}'$ du résonateur ; cette distance $d_{mr}'$ est choisie selon le même critère que la distance $d_{mr}$ : elle est telle que la ligne 11 et le résonateur 5 puissent être couplés, mais elle n'est pas nécessairement égale à la distance $d_{mr}$. Selon le mode de réalisation considéré, la ligne 9 ne passe pas "sous" la ligne 11. Il est cependant possible de réaliser un dispositif selon l'invention, analogue à celui de la figure 9, comportant une ligne 9 passant "sous" la ligne 11 et même "dépassant" de celle-ci.

Les éléments de la figure 9 qui sont représentés aussi sur les figures 3 et 4 forment un ensemble qui se comporte en transmission comme un filtre réjecteur de bande, comme cela a été expliqué précédemment. La partie du signal injectée à l'entrée 28 de la ligne 8 et correspondant à la bande de fréquence rejetée par le couplage entre la ligne 8 et le résonateur 5, passe dans la ligne 11, après avoir été modifiée par une interaction magnétique entre le résonateur 5 et la ligne 11 : autrement dit, la ligne secondaire 11 constitue, pour un signal hyperfréquence injecté à l'entrée 28 de la ligne 8, la sortie d'un filtre passe-bande dans la mesure où les impédances de sorties des lignes 8 et 11 sont respectivement sensiblement égales à leurs impédances caractéristiques, comme par exemple égales à 50 , Le dispositif de la figure 9 est accordable, et un tel accord est réalisé grâce à la commande de la tension V appliquée au varactor 7.

Le dispositif des figures 3 et 4, 5, ou 6, est susceptible, lorsqu'il est associé, par exemple comme dispositif de réaction accordable, à un autre circuit hyperfréquence présentant une résistance négative, comme par exemple à un transistor hyperfréquence, de constituer un oscillateur hyperfréquence, à résonateur diélectrique, accordable, compact, et dont la bande d'accord est nettement plus étendue que celle des oscillateurs du même type connus. Le choix de la tension V permet de sélectionner la fréquence centrale du signal généré par l'oscillateur.

Le dispositif de la figure 9 permet de réaliser un discriminateur de fréquence hyperfréquence, dont la courbe de conversion fréquence-amplitude, appelée "caractéristique fréquence-amplitude" dans ce qui suit, est analogue à celle d'un discriminateur de Travis couramment utilisé pour des fréquences plus basses, ledit discriminateur étant en outre accordable en fréquence, c'est-à-dire ayant une caractéristique fréquence-amplitude susceptible d'être déplacée en fréquence. En plus du dispositif de la figure 9, le discriminateur selon l'invention comporte un circuit de détection à diodes relié aux sorties des lignes 8 et 11 et réalisant une combinaison des signaux en opposition de la manière connue pour les discriminateurs de Travis. Dans ce cas, la connexion du circuit de détection à diodes aux lignes 8 et 11 introduit une déformation de la courbe de réponse en fréquence à la sortie de la ligne 11, ce qui permet d'obtenir la caractéristique fréquence-amplitude de discrimination connue, symétrique par rapport à la fréquence centrale du discriminateur. De plus, ce discriminateur est accordable : un changement de la tension V appliquée aux bornes du varactor 7 entraîne un déplacement global de la caractéristique fréquence-amplitude.

Un discriminateur accordable, tel que celui décrit dans le paragraphe précédent, peut être appliqué à la stabilisation en fréquence d'un oscillateur accordable, comme par exemple un oscillateur à résonateur diélectrique, comportant le dispositif des figures 3 et 4, ou 5, ou 6, et précédemment décrit. Le discriminateur est alors intégré dans une boucle à asservissement de fréquence, et permet de réduire notablement le bruit de phase de l'oscillateur sur toute la bande d'accord de ce dernier : le discriminateur étant accordable, sa caractéristique fréquence-amplitude peut posséder une pente élevée (en valeur absolue) et de ce fait comprimer fortement ledit bruit, la bande d'accord du discriminateur étant évidemment déterminée de manière à ce que la caractéristique fréquence-amplitude de ce discriminateur soit susceptible de se déplacer sur tout le domaine de fréquence correspondant à la bande d'accord de l'oscillateur. Une réduction du bruit de phase d'un oscillateur accordable sur toute sa bande d'accord pourrait aussi être obtenue avec un discriminateur non accordable, dont la caractéristique fréquence-amplitude couvrirait toute la bande d'accord de l'oscillateur, mais la pente d'une telle caractéristique serait faible ; la compression dudit bruit serait donc faible.

D'autres modes de réalisation du dispositif selon l'invention et d'autres applications peuvent être obtenus en modifiant au moins l'un des facteurs suivants :
- le nombre de lignes microrubans ;
- le nombre de résonateurs diélectriques ;
- le nombre de lignes coplanaires ;
- le nombre de varactors ;
- la géométrie des différents éléments tout en conservant la nature des couplages, c'est-à-dire en conservant l'emplacement par rapport au diélectrique des lignes microrubans et des résonateurs diélectriques d'une part, et des lignes coplanaires et des varactors d'autre part.

Une généralisation du mode de réalisation de la figure 9, obtenue en rajoutant des lignes microruban secondaires 11 et entre elles des résonateurs 5, ainsi que les lignes coplanaires et les varactors correspondants, rentrerait par exemple dans le cadre de l'invention.

## Revendications

1. Dispositif filtrant hyperfréquence accordable comportant :
- une première ligne microruban (8) ;
- un résonateur diélectrique (5) couplé à ladite première ligne microruban (8) ;
- un élément actif (7), couplé au résonateur diélectrique (5) et dont l'impédance variable permet d'accorder le dispositif en fréquence, caractérisé en ce qu'il comporte en outre une ligne coplanaire (9) couplée au résonateur (5), l'élément actif (7) étant rapporté sur la ligne coplanaire (9).

2. Dispositif selon la revendication 1, caractérisé en ce que l'élément actif (7) est un varactor auquel on applique une tension (V) variable, cette variation permettant de modifier l'impédance du varactor (7).

3. Dispositif selon la revendication 2, caractérisé en ce que :
- le résonateur diélectrique (5) est situé à côté de ladite première ligne microruban (8) ;
- la ligne coplanaire (9), réalisée sur la face qui constitue le plan de masse (3) de ladite première ligne microruban (8), est sensiblement perpendiculaire à ladite première ligne microruban (8) et située près du résonateur (5), le dispositif obtenu constituant en transmission un filtre réjecteur de bande et accordable.

4. Dispositif selon la revendication 2, caractérisé en ce que :
- le résonateur diélectrique (5) est situé à côté de ladite première ligne microruban (8) ;
- la ligne coplanaire (9), réalisée sur la face qui constitue le plan de masse (3) de ladite première ligne microruban (8), est sensiblement parallèle à ladite première ligne microruban (8) et située prés du résonateur (5),
le dispositif obtenu constituant en transmission un filtre réjecteur de bande et accordable.

5. Dispositif selon la revendication 3, caractérisé en ce qu'il comporte en outre une seconde ligne microruban (11) sensiblement parallèle à ladite première ligne microruban (8) et couplée audit résonateur (5), le dispositif ainsi obtenu constituant :
- en transmission un filtre réjecteur de bande et accordable ;
- pour un signal injecté le long de ladite ligne microruban (8) et sortant par ladite seconde ligne microruban (11), un filtre passe-bande et accordable.

6. Oscillateur hyperfréquence, à résonateur diélectrique, accordable, caractérisé en ce qu'il comporte un dispositif selon l'une des revendications 1 à 4.

7. Discriminateur de fréquence hyperfréquence accordable, caractérisé en ce qu'il comporte :
- un dispositif selon la revendication 3 ;
- une seconde ligne microruban (11) sensiblement parallèle à ladite première ligne microruban (8) et couplée audit résonateur (5) ;
les signaux de sortie de ladite première ligne (8) et de ladite seconde ligne (11) étant combinés par des moyens de détection à diodes pour obtenir la caractéristique fréquence-amplitude de discrimination en fréquence.

8. Oscillateur hyperfréquence accordable stabilisé en fréquence par discriminateur, caractérisé en ce que l'oscillateur comporte un discriminateur accordable selon la revendication 7, ce qui assure une stabilisation de l'oscillateur sur toute la bande d'accord de ce dernier au moyen d'un déplacement en fréquence de la caractéristique fréquence-amplitude du discriminateur, le déplacement en fréquence de ladite caractéristique étant obtenu grâce à la commande de la tension (V) appliquée audit varactor (7).

FIG. 1

FIG. 2

0296009

FIG. 3

FIG. 4

FIG. 5

FIG. 6

0296009

FIG. 7

FIG. 8

**FIG. 9**

**Office européen des brevets**

# RAPPORT DE RECHERCHE EUROPEENNE

Numero de la demande

EP 88 40 1347

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | FR-A-2 438 937 (THOMSON-CSF) <br> * En entier * <br> --- | 1-6 | H 01 P 7/10 |
| Y | EP-A-0 069 431 (C.I.S.E.) <br> * Résumé; figure 3 * <br> --- | 1-6 | |
| A | EP-A-0 190 613 (ALCATEL) <br> * Résumé; figures 2,3,6 * <br> ----- | 7,8 | |

**DOMAINES TECHNIQUES RECHERCHES (Int. Cl.4)**

H 01 P

Le présent rapport a été établi pour toutes les revendications

| Lieu de la recherche | Date d'achèvement de la recherche | Examinateur |
|---|---|---|
| LA HAYE | 08-09-1988 | LAUGEL R.M.L. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................................
& : membre de la même famille, document correspondant

EPO FORM 1503 03.82 (P0402)